# EUROPEAN PATENT APPLICATION

(11) **EP 4 557 600 A1**
(43) Date of publication of application: **21.05.2025**
(21) Application number: 23839650.1
(22) Date of filing: 12.07.2023
(51) Int. Cl.: H02M 7/48

(54) **WIRING MEMBER FOR ELECTRICAL INSTRUMENT, AND POWER CONVERSION DEVICE**

(30) Priority: 12.07.2022 JP 2022111741
(71) Applicant: Hitachi Industrial Products, Ltd., Tokyo 101-0021 (JP)
(72) Inventor: MURAKAMI Daichi, Tokyo 101-0021 (JP); TAKAHASHI Akihiro, Tokyo 101-0021 (JP)
(74) Representative: MERH-IP Matias Erny Reichl Hoffmann Patentanwälte PartG mbB
(86) International application number: PCT/JP2023/025733
(87) International publication number: WO 2024/014478

(57) **Abstract**

The present invention provides a wiring member for an electrical instrument and a power conversion device using this wiring member in which an inductance and a power loss can be reduced in a high-frequency current. A wiring member (50) for an electrical instrument according to the present invention includes a plurality of first conductors (2a, 2b) electrically connected and laminated with each other, a second conductor (8) provided between the first conductors (2a, 2b) and not electrically connected with any other conductors, and insulating materials (1) provided between each of the first conductors (2a, 2b) and the second conductor (8).

## Description

### TECHNICAL FIELD OF THE INVENTION

The present invention relates to a wiring member for an electrical instrument and a power conversion device, particularly to a wiring member through which a high-frequency current is passed and a power conversion device including this wiring member.

### BACKGROUND ART

A wiring member conducting a high-frequency current may be required to reduce an inductance. For example, in a power conversion device, power is converted between a direct current and an alternating current by on/off operation of a switching element. When the switching element is turned off, a surge voltage is applied to the switching element by variation in current and an inductance of a wiring member connected to the switching element, and the switching element can be broken. For this reason, a wiring member is required to reduce an inductance. In addition, a wiring member is required to reduce a power loss for efficient current conduction.

With respect to a conductor as a wiring member, Patent Literature 1 discloses an example of a technology for reducing an inductance. Patent Literature 1 discloses a power conversion device which includes a laminated busbar formed by stacking a conductor (busbar) connected to a positive electrode of a DC power source and a conductor connected to a negative electrode thereof with an insulator sandwiched therebetween and in which an inductance is reduced by the laminated busbar so configured that the conductors are disposed close to each other with the insulating material in between.

With respect to a wiring member, Patent Literature 2 discloses an example of a technology for reducing a power loss in a high-frequency current. Patent Literature 2 discloses a wiring member for high-frequency current that is configured by laminating plural pieces of sheet metal and an insulating material insulating adjoining pieces of the sheet metal from each other and reduces an influence of a skin effect to reduce a power loss.

### DOCUMENT LIST

### PATENT DOCUMENT

Patent Literature 1: JP 2008-245451 A
Patent Literature 2: JP 2005-269873 A

### SUMMARY OF INVENTION

### TECHNICAL PROBLEM

With conventional technologies, it is difficult for a wiring member to reduce an inductance and a power loss to a level at which users are sufficiently satisfied.

For example, with the technology in Patent Literature 1, when the frequency of a current is increased, the current is passed only in the surface of a conductor because of an influence of a skin effect and the current is not passed inside the conductor. Therefore, it is difficult to reduce an inductance and a power loss. With the technology in Patent Literature 2, an influence of a skin effect can be reduced but an inductance or a power loss may not be sufficiently reduced because of a proximity effect occurring between plural pieces of sheet metal, that is, a phenomenon in which a magnetic flux produced by a current passed through a piece of sheet metal gives an influence on another piece of sheet metal and makes the current difficult to flow.

It is an object of the present invention to provide a wiring member for an electrical instrument and a power conversion device using this wiring member, which can reduce an inductance and a power loss in a high-frequency current.

### SOLUTION TO PROBLEM

A wiring member for an electrical instrument, according to the present invention includes a plurality of first conductors electrically connected and laminated with each other, a second conductor provided between the first conductors and not electrically connected with any other conductors, and insulating materials provided between each of the first conductors and the second conductor.

A power conversion device according to the present invention includes a capacitor, a switching element that switches a DC current on and off, and a wire connecting the capacitor and the switching element. The wire is the wiring member according to the present invention, having two members each including the first conductors, the second conductor, and the insulating materials. The two members are opposed to each other in the laminating direction of the first conductors and include an insulating material between the members. The first conductors of one of the members are connected with a positive electrode of a DC power supply. The first conductors of the other of the members are connected with a negative electrode of the DC power supply.

### ADVANTAGEOUS EFFECTS OF INVENTION

According to the present invention, a wiring member for an electrical instrument and a power conversion device using this wiring member are provided, which can reduce an inductance and a power loss in a high-frequency current.

### BRIEF DESCRIPTION OF DRAWINGS

FIG. 1 is a cross-sectional view of a wiring member, illustrating an example of a configuration of the wiring member according to a first embodiment of the present invention.
FIG. 2A is a front view of a laminate busbar, illustrating an example of a laminate busbar as a wiring member according to a second embodiment of the present invention.
FIG. 2B is a cross-sectional view taken along line A-A of FIG. 2A.
FIG. 3A is a front view of a laminate busbar, illustrating an example of a configuration in which an end portion of the laminate busbar is connected with an external device in the second embodiment.
FIG. 3B is a cross-sectional view taken along line B-B of FIG. 3A.
FIG. 4A is a front view of a laminate busbar, illustrating an example of a structure of an end portion of the laminate busbar in the second embodiment.
FIG. 4B is a cross-sectional view taken along line C-C of FIG. 4A.
FIG. 5A is a front view of a laminate busbar, illustrating another example of a structure of an end portion of the laminate busbar in the second embodiment.
FIG. 5B is a cross-sectional view taken along line D-D of FIG. 5A.
FIG. 6A is a front view of a multilayer printed circuit board, illustrating an example of a multilayer printed circuit board as a wiring member according to a third embodiment of the present invention.
FIG. 6B is a cross-sectional view taken along line E-E of FIG. 6A.
FIG. 7A is a front view of a busbar, illustrating an example of a busbar as a wiring member according to a fourth embodiment of the present invention.
FIG. 7B is a cross-sectional view taken along line F-F of FIG. 7A.
FIG. 8 is a drawing illustrating a circuit configuration of a power conversion device according to a fifth embodiment of the present invention.

### DESCRIPTION OF EMBODIMENTS

A wiring member for an electrical instrument according to the present invention includes at least one of a positive electrode conductor and a negative electrode conductor formed by laminating a plurality of conductors, and an electromagnetic shield disposed between laminated conductors. A wiring member according to the present invention can reduce an inductance and a power loss in a high-frequency current owing to an effect of the electromagnetic shield as a conductor.

A power conversion device according to the present invention includes a wiring member according to the present invention and can reduce an inductance and a power loss in a high-frequency current.

Hereafter, a detailed description will be given to a wiring member for an electrical instrument and a power conversion device according to embodiments of the present invention with reference to the drawings. The embodiments described below are examples for explaining the present invention and the present invention is not limited to these embodiments. Therefore, the present invention is not limited to the following embodiments without departing from the subject matter thereof and can be embodied in various modes. In the drawings accompanying the present specification, the identical or equivalent components will be marked with the identical reference signs and a repetitive description of these components may be omitted.

### FIRST EMBODIMENT

A description will be given to a wiring member for an electrical instrument according to the first embodiment of the present invention. In the present embodiment, a basic configuration of a wiring member will be described for reducing an inductance and a power loss in a high-frequency current.

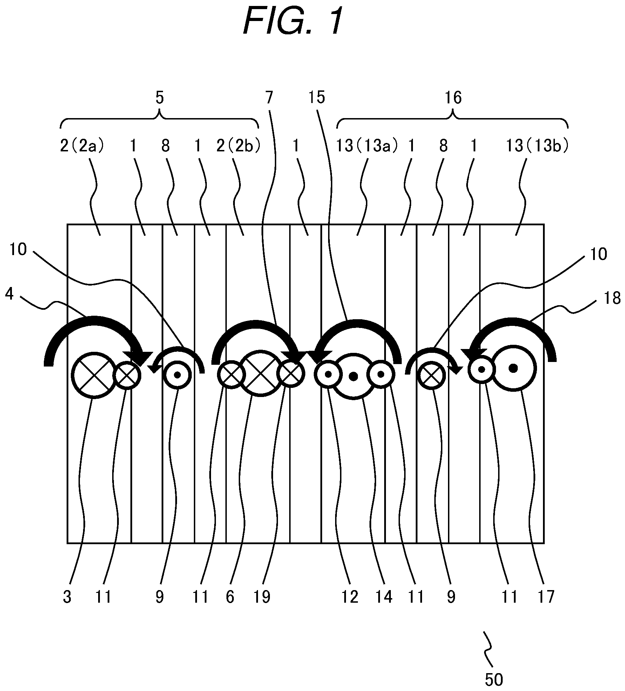

FIG. 1 is a drawing illustrating an example of a configuration of a wiring member 50 according to the present embodiment and is a cross-sectional view of the wiring member 50. The wiring member 50 according to the present embodiment includes a positive electrode wiring member 5, a negative electrode wiring member 16, and an insulating material 1 disposed between the positive electrode wiring member 5 and the negative electrode wiring member 16.

The positive electrode wiring member 5 includes a positive electrode conductor 2, an electromagnetic shield 8, and insulating materials 1. The negative electrode wiring member 16 includes a negative electrode conductor 13, an electromagnetic shield 8, and insulating materials 1.

The positive electrode conductor 2 is formed by laminating a plurality of flat plate-like conductors electrically connected to each other. The number of the conductors laminated and electrically connected with each other can be arbitrarily determined. In the following description, a case where the number of the conductors is two will be described as an example. That is, it is assumed that the positive electrode conductor 2 is formed by laminating two flat plate-like conductors, a positive electrode conductor 2a and a positive electrode conductor 2b, electrically connected with each other.

Similarly to the positive electrode conductor 2, the negative electrode conductor 13 is also formed by laminating a plurality of flat plate-like conductors electrically connected with each other. The number of these conductors can be arbitrarily determined. In the following description, a case where the number of the conductors is two will be described as an example. That is, it is assumed that the negative electrode conductor 13 is formed by laminating two flat plate-like conductors, a negative electrode conductor 13a and a negative electrode conductor 13b, electrically connected with each other.

Each of the electromagnetic shields 8 is provided between the conductors constituting the positive electrode conductor 2 and between the conductors constituting the negative electrode conductor 13. In the example shown in FIG. 1, the electromagnetic shields 8 is each provided between the positive electrode conductor 2a and the positive electrode conductor 2b and between the negative electrode conductor 13a and the negative electrode conductor 13b. When the positive electrode conductor 2 and the negative electrode conductor 13 are formed by laminating three or more conductors, the electromagnetic shield 8 is each provided between conductors of the three or more conductors. The electromagnetic shield 8 is formed of a flat plate-like conductor and is not electrically connected to any other conductors such as the positive electrode conductors 2a, 2b and the negative electrode conductors 13a, 13b.

The positive electrode conductor 2, the negative electrode conductor 13, and the electromagnetic shields 8 can be formed of a material such as copper or aluminum.

The insulating materials 1 is provided each of between the positive electrode conductor 2a and the electromagnetic shield 8 and between the electromagnetic shield 8 and the positive electrode conductor 2b. Further, the insulating material 1 is provided each of between the negative electrode conductor 13a and the electromagnetic shield 8 and between the electromagnetic shield 8 and the negative electrode conductor 13b. The electromagnetic shields 8 are insulated from the positive electrode conductor 2 and the negative electrode conductor 13 by these insulating materials 1. As mentioned above, an insulating material 1 is also provided between the positive electrode wiring member 5 and the negative electrode wiring member 16. The insulating materials 1 are solids, gas, or liquid and are, for example, glass epoxy resin, air, or insulating oil.

The wiring member 50 according to the present embodiment may include only one of the positive electrode wiring member 5 and the negative electrode wiring member 16 and may be include both the positive electrode wiring member 5 and the negative electrode wiring member 16 as shown in FIG. 1. That is, the wiring member 50 according to the present embodiment can include either or both of the positive electrode conductor 2 and the negative electrode conductor 13.

In a configuration in which the wiring member 50 includes both the positive electrode wiring member 5 and the negative electrode wiring member 16, the positive electrode wiring member 5 and the negative electrode wiring member 16 are so arranged that the laminating direction of the positive electrode conductors 2a, 2b and the laminating direction of the negative electrode conductors 13a, 13b agree with each other and are opposed to each other in these laminating directions to form the wiring member 50. In the example shown in FIG. 1, an insulating material 1 disposed between the positive electrode wiring member 5 and the negative electrode wiring member 16 is provided between the positive electrode conductor 2b and the negative electrode conductor 13a.

To the positive electrode conductor 2 (2a, 2b) of the positive electrode wiring member 5, an electrode, for example, a positive electrode of a DC power supply can be connected. To the negative electrode conductor 13 (13a, 13b) of the negative electrode wiring member 16, an electrode, for example, a negative electrode of a DC power supply can be connected. The positive electrode conductor 2 and the negative electrode conductor 13 conduct a current when electrodes of a DC power supply are connected.

When a DC current is conducted, the wiring member 50 according to the present embodiment reduces an inductance and a power loss with respect to high frequency components in the DC current. In the present specification, not only a high-frequency AC current but also high frequency components in a DC current will be designated as high-frequency current.

As shown in FIG. 1, it is assumed that for the positive electrode conductor 2 of the positive electrode wiring member 5, a current is passed in a direction orthogonal to the laminating direction (the crosswise direction in FIG. 1) of the positive electrode conductors 2a, 2b. (For example, a current is passed in the direction going from the near side toward the far side in the plane of FIG. 1.) When a current 3 is passed through the positive electrode conductor 2a, a magnetic flux 4 is produced by the current 3. When a current 6 is passed through the positive electrode conductor 2b, a magnetic flux 7 is produced by the current 6.

When the magnetic flux 4 and the magnetic flux 7 are interlinked with the electromagnetic shield 8, an eddy current 9 is produced in the opposite direction to the currents 3, 6 in the electromagnetic shield 8. This eddy current 9 produces a magnetic flux 10 around the electromagnetic shield 8. When this magnetic flux 10 is interlinked with the positive electrode conductor 2a and the positive electrode conductor 2b, an eddy current 11 is produced in a plane opposed to the electromagnetic shield 8 in the positive electrode conductor 2a and the positive electrode conductor 2b. This eddy current 11 flows in the same direction with the currents 3, 6 and does not prevent conduction of the currents 3, 6.

For this reason, in the positive electrode conductor 2a and the positive electrode conductor 2b, a high-frequency current is easily conducted in the planes opposed to the electromagnetic shield 8. Therefore, the positive electrode wiring member 5 of the wiring member 50 according to the present embodiment reduces an inductance and a power loss in a high-frequency current.

The negative electrode wiring member 16 has the same configuration as that of the positive electrode wiring member 5. For this reason, in the negative electrode conductor 13a and the negative electrode conductor 13b, a high-frequency current is easily conducted in planes opposed to the electromagnetic shield 8 on the same principle as the principle in the positive electrode wiring member 5. Therefore, the negative electrode wiring member 16 of the wiring member 50 according to the present embodiment reduces an inductance and a power loss in a high-frequency current. Note that, since the direction of the currents 14, 17 passed through the negative electrode conductors 13a, 13b is opposite to the direction of the currents 3, 6 passed through the positive electrode conductors 2a, 2b, the direction of the magnetic fluxes 15, 18 produced by the currents 14, 17 is opposite to the direction of the magnetic fluxes 4, 7 produced in the positive electrode wiring member 5. Further, the direction of the eddy current 9 produced in the electromagnetic shield 8 by the magnetic fluxes 15, 18 and the direction of the magnetic flux 10 produced around the electromagnetic shield 8 are also opposite to the directions in the positive electrode wiring member 5. The direction of the eddy current 11 produced in the planes of the negative electrode conductors 13a, 13b opposed to the electromagnetic shield 8 is also opposite to the direction in the positive electrode wiring member 5.

In the wiring member 50 according to the present embodiment, the positive electrode wiring member 5 and the negative electrode wiring member 16 are opposed to each other with the insulating material 1 in between. For this reason, by the magnetic fluxes produced in the positive electrode conductor 2b and the negative electrode conductor 13a, an eddy current 19 and an eddy current 12 are respectively produced in the planes of the positive electrode wiring member 5 and the negative electrode wiring member 16 opposed to the insulating material 1 (that is, in the planes of the positive electrode conductor 2b and the negative electrode conductor 13a opposed to the insulating material 1). The eddy current 19 and the eddy current 12 respectively flow in the same directions with the current 6 and the current 14 and do not prevent conduction of the currents 6, 14.

For this reason, in the positive electrode conductor 2b and the negative electrode conductor 13a, a high-frequency current is easily conducted in the planes opposed to the insulating material 1 between the positive electrode wiring member 5 and the negative electrode wiring member 16. Therefore, the positive electrode wiring member 5 and the negative electrode wiring member 16 of the wiring member 50 according to the present embodiment reduces an inductance and a power loss in a high-frequency current.

The wiring member 50 according to the present embodiment includes the electromagnetic shield 8 not electrically connected to any other conductors, and reduces an inductance and a power loss in a high-frequency current by producing the eddy current 9 in the electromagnetic shield 8 and producing the eddy current 11 in the positive electrode conductor 2 and the negative electrode conductor 13.

Note that the configuration and the directions of the currents shown in FIG. 1 shows an example of the wiring member 50 according to the present embodiment. For example, even when the directions of the currents 3, 6 and the currents 14, 17 are inverted in the wiring member 50, the same effects as in the present embodiment can be obtained.

### SECOND EMBODIMENT

A description will be given to a wiring member 50 for an electrical instrument according to the second embodiment of the present invention. In the present embodiment, a laminate busbar formed by laminating insulating materials and conductors will be described as an example of the wiring member 50.

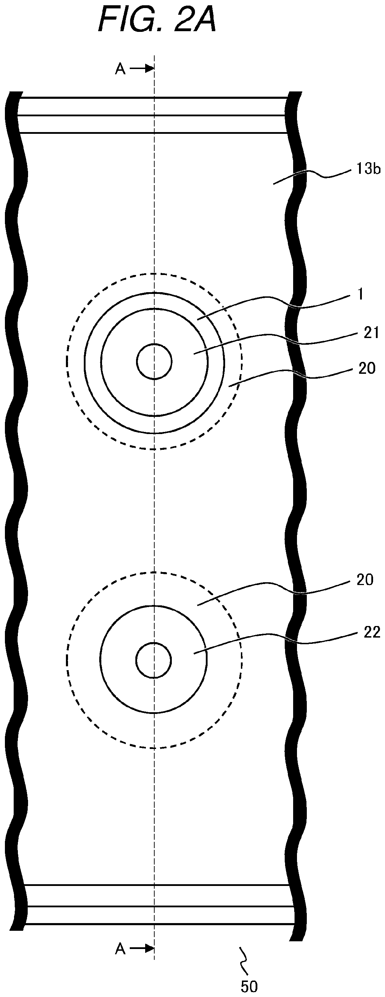

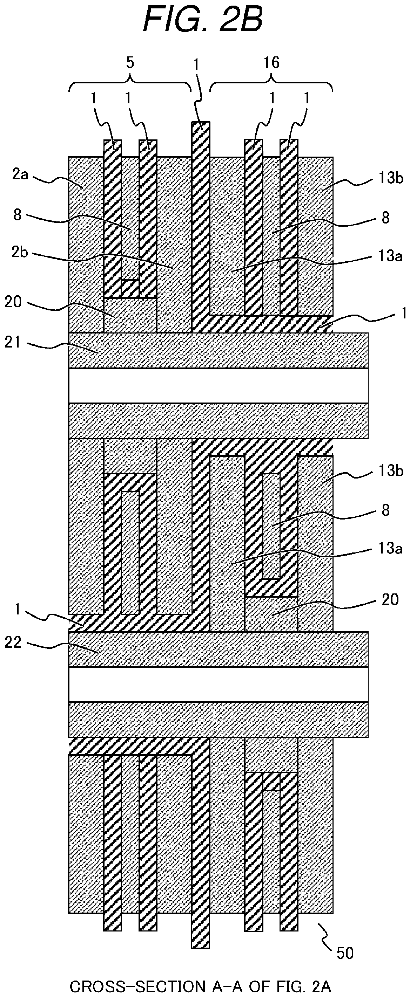

FIG. 2A and FIG. 2B are drawings illustrating an example of the laminate busbar as the wiring member 50 according to the present embodiment. FIG. 2A is a front view of the laminate busbar and FIG. 2B is a cross-sectional view taken along line A-A of FIG. 2A.

The laminate busbar shown in FIG. 2A and FIG. 2B includes a positive electrode wiring member 5, a negative electrode wiring member 16, and an insulating material 1 provided between the positive electrode wiring member 5 and the negative electrode wiring member 16. The positive electrode wiring member 5 includes a positive electrode conductor 2 (2a, 2b), an electromagnetic shield 8, and insulating materials 1 located therebetween. The negative electrode wiring member 16 includes a negative electrode conductor 13 (13a, 13b), an electromagnetic shield 8, insulating materials 1 located therebetween.

A description will be given to configurations of electrodes of the laminate busbar.

On the positive electrode of the laminate busbar, the positive electrode conductor 2a and the positive electrode conductor 2b are electrically connected with each other through a spacer 20. The spacer 20 is a conductor and is, for example, a ring-shaped metal member. The positive electrode conductor 2a and the positive electrode conductor 2b, and the spacer 20 are mechanically connected by, for example, spot welding.

The laminate busbar includes a positive electrode 21. The positive electrode 21 is electrically connected to the positive electrode conductor 2a and the positive electrode conductor 2b. The positive electrode 21 can be formed of, for example, a metal cylinder and can be installed in the laminate busbar by, for example, press fit. An insulating material 1 is disposed between the positive electrode 21 and the negative electrode conductor 13 to insulate the positive electrode 21 and the negative electrode conductor 13 from each other.

The negative electrode of the laminate busbar has the same configuration as that of the positive electrode. The negative electrode conductor 13a and the negative electrode conductor 13b are electrically connected to each other through a spacer 20. The laminate busbar includes a negative electrode 22 electrically connected to the negative electrode conductor 13a and the negative electrode conductor 13b. Between the negative electrode 22 and the positive electrode conductor 2, an insulating material 1 is disposed to insulate the negative electrode 22 and the positive electrode conductor 2 from each other.

The positive electrode 21 and the negative electrode 22 includes a through hole for passing a screw that fixes an external device such as a capacitor and a switching element. In the laminate busbar shown in FIG. 2A and FIG. 2B, an external device is connected to the positive electrode 21 and the negative electrode 22 at the inner circumferential portion of the laminate busbar. The laminate busbar may also have a configuration that an external device is connected to the positive electrode 21 and the negative electrode 22 at an end portion of the laminate busbar.

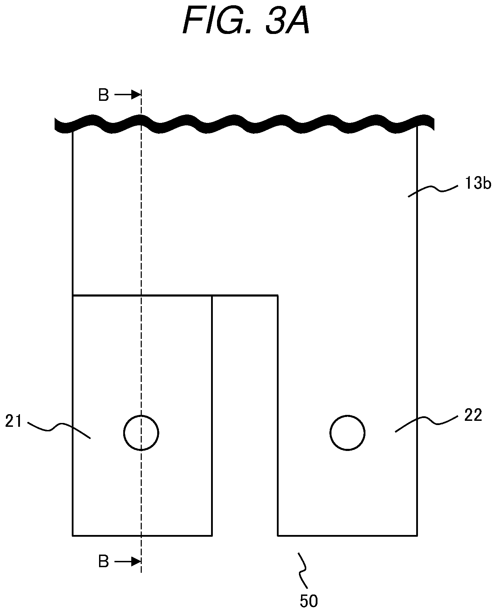

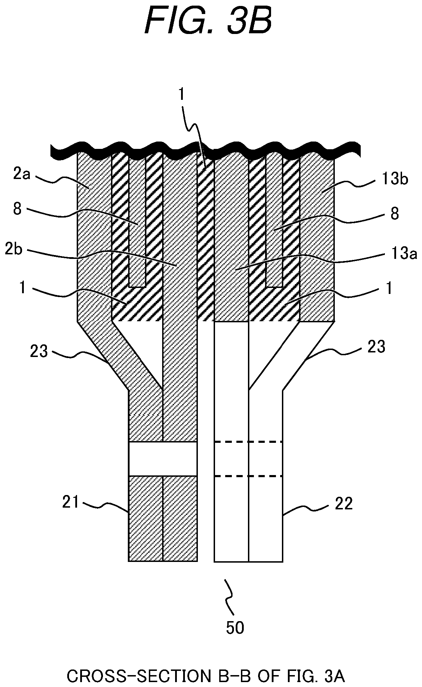

FIG. 3A and FIG. 3B are drawings illustrating an example of a configuration in which the laminate busbar as the wiring member 50 according to the present embodiment is connected with an external device at an end portion of the laminate busbar. FIG. 3A is a front view of the laminate busbar and FIG. 3B is a cross-sectional view taken along line B-B of the FIG. 3A.

As shown in FIG. 3B, the positive electrode conductor 2a includes a step-bent portion 23 at an end portion of the laminate busbar and is bent at the step-bent portion 23 and is brought into contact with the positive electrode conductor 2b. The positive electrode conductor 2a and the positive electrode conductor 2b are mechanically connected with each other by, for example, spot welding. The junction between the positive electrode conductor 2a and the positive electrode conductor 2b is formed as a positive electrode 21 and has a through hole for passing a screw that fixes an external device.

The negative electrode conductor 13b has the same configuration as the positive electrode conductor 2a and is bent at a step-bent portion 23 and is brought into contact with the negative electrode conductor 13a. The junction between the negative electrode conductor 13a and the negative electrode conductor 13b is formed as a negative electrode 22 and has a through hole for passing a screw that fixes an external device.

It is preferable that, as shown in FIG. 3A, the positive electrode 21 and the negative electrode 22 are separately positioned from each other so that an external device can be easily connected.

In the laminate busbar as the wiring member 50 according to the present embodiment, as shown FIGS. 2A and 2B and FIGS. 3A and 3B, the positive electrode 21 and the negative electrode 22 each include a through hole. These through holes can be utilized to connect an external device, such as a capacitor and a switching element, by screwing.

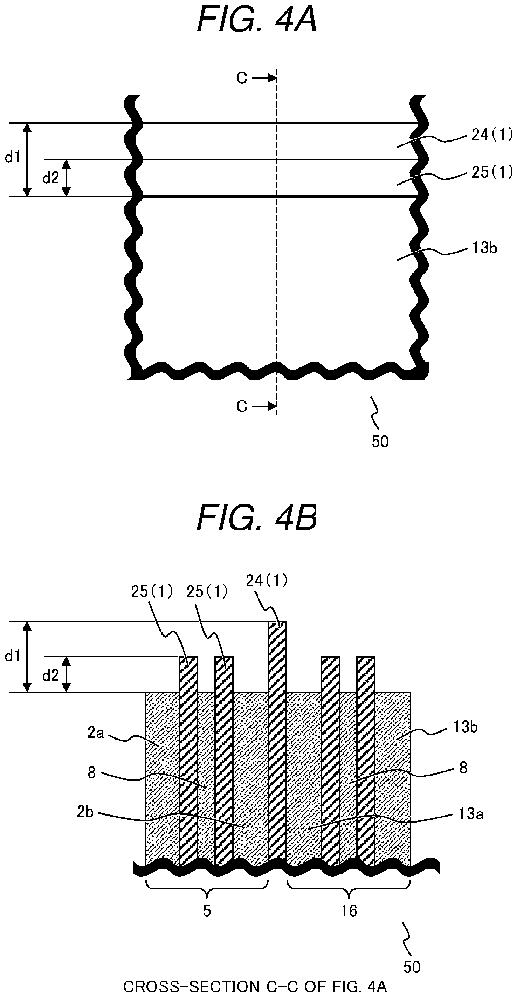

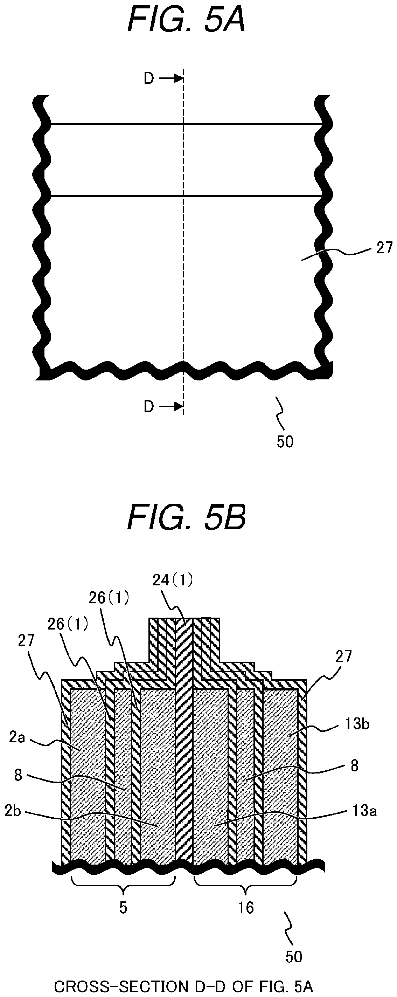

With reference to FIGS. 4A and 4B and FIGS. 5A and 5B, a description will be given to an example of a structure of an end portion of the laminate busbar as the wiring member 50 according to the present embodiment.

FIG. 4A and FIG. 4B are drawings illustrating an example of a structure of an end portion of a laminate busbar as the wiring member 50 according to the present embodiment. FIG. 4A is a front view of the laminate busbar and FIG. 4B is a cross-sectional view taken along line C-C of the FIG. 4A.

As shown in FIG. 4B, in the positive electrode wiring member 5, electromagnetic shield insulating plates 25 as the insulating materials 1 are installed between the positive electrode conductor 2a and the electromagnetic shield 8 and between the electromagnetic shield 8 and the positive electrode conductor 2b. The electromagnetic shield insulating plates 25 are bonded to the positive electrode conductors 2a, 2b and the electromagnetic shield 8. The negative electrode wiring member 16 also has the same configuration as the positive electrode wiring member 5. A between-positive-negative-electrodes insulating plate 24 as the insulating material 1 is installed between the positive electrode wiring member 5 and the negative electrode wiring member 16.

The protruding length of the electromagnetic shield insulating plate 25 from the positive electrode conductors 2a, 2b and the negative electrode conductors 13a, 13b is taken as d2. The protruding length of the between-positive-negative-electrodes insulating plate 24 from the positive electrode conductors 2a, 2b and the negative electrode conductors 13a, 13b is taken as d1.

The length d2 is preferably equal to or shorter than the length d1 (d2≤d1). In the laminate busbar, a potential difference is large between the positive electrode conductor 2 and the negative electrode conductor 13. For this reason, a specific length is required for the length d1 so that the creeping distance is increased between the positive electrode conductor 2 and the negative electrode conductor 13. Meanwhile, a potential difference between the positive electrode conductors 2a, 2b and the electromagnetic shield 8 and a potential difference between the negative electrode conductors 13a, 13b and the electromagnetic shield 8 are smaller than a potential difference between the positive electrode conductor 2 and the negative electrode conductor 13. For this reason, the length d2 can be shorter than the length d1 (d2<d1). Although the length d2 may be equal to the length d1 (d2=d1), when the length d2 is shorter than the length d1, an advantage will be yielded that the quantity of insulating material to be used is reduced.

In the example shown in FIG. 4A and FIG. 4B, the electromagnetic shield insulating plate 25, that is, a plate-like insulating material is used as the insulating material 1 insulating the electromagnetic shield 8. As mentioned above, the potential difference between the electromagnetic shield 8 and the positive electrode conductor 2 and the potential difference between the electromagnetic shield 8 and the negative electrode conductor 13 are small. For this reason, a thin film-like insulating material, for example, a thin sheet or a thin film can be used as the insulating material 1 insulating the electromagnetic shield 8. Hereafter, a description will be given to a structure of an end portion of a laminate busbar using an insulating sheet as the insulating material 1 insulating the electromagnetic shield 8.

FIG. 5A and FIG. 5B are drawings illustrating another example of a structure of an end portion of a laminate busbar as the wiring member 50 according to the present embodiment. FIG. 5A is a front view of the laminate busbar and FIG. 5B is a cross-sectional view taken along line D-D of FIG. 5A.

As shown in FIG. 5B, in the positive electrode wiring member 5, electromagnetic shield insulating sheets 26 as the insulating material 1 are installed between the positive electrode conductor 2a and the electromagnetic shield 8 and between the electromagnetic shield 8 and the positive electrode conductor 2b. The electromagnetic shield insulating sheets 26 are bonded to the positive electrode conductors 2a, 2b and the electromagnetic shield 8. The negative electrode wiring member 16 also has the same configuration as the positive electrode wiring member 5. A between-positive-negative-electrodes insulating plate 24 as the insulating material 1 is installed between the positive electrode wiring member 5 and the negative electrode wiring member 16.

A side face insulating sheet 27 is stuck to the side faces of the positive electrode wiring member 5 and the negative electrode wiring member 16 (that is, the side faces of the positive electrode conductor 2a and the negative electrode conductor 13b).

At an end portion of the laminate busbar, the electromagnetic shield insulating sheets 26 are laid over the side face insulating sheet 27 and bonded to the between-positive-negative-electrodes insulating plate 24.

The laminate busbar as the wiring member 50 according to the present embodiment, similar to the wiring member 50 according to the first embodiment, can reduce an inductance and a power loss in a high-frequency current. In addition, with a configuration as shown in FIGS. 4A and 4B and FIGS. 5A and 5B, the wiring member 50 according to the present embodiment can effectively insulate the electromagnetic shield 8 from the positive electrode conductor 2 and the negative electrode conductor 13 at an end portion of the laminate busbar.

### THIRD EMBODIMENT

A description will be given to a wiring member 50 for an electrical instrument according to the third embodiment of the present invention. In the present embodiment, a multilayer printed circuit board will be described as an example of the wiring member 50.

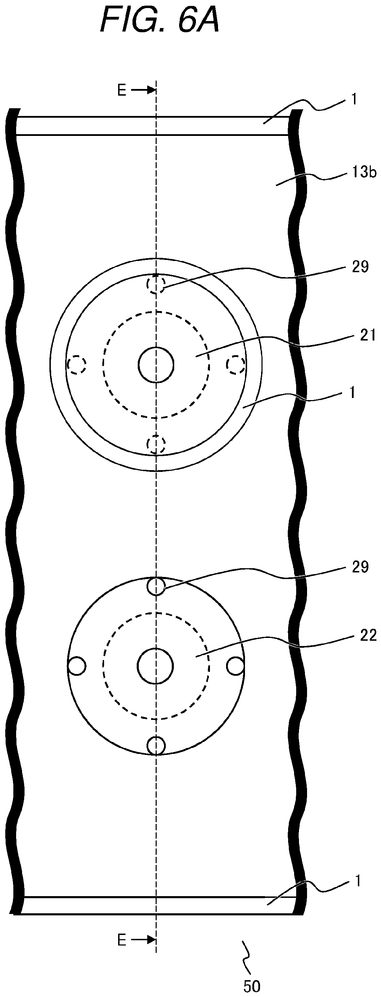

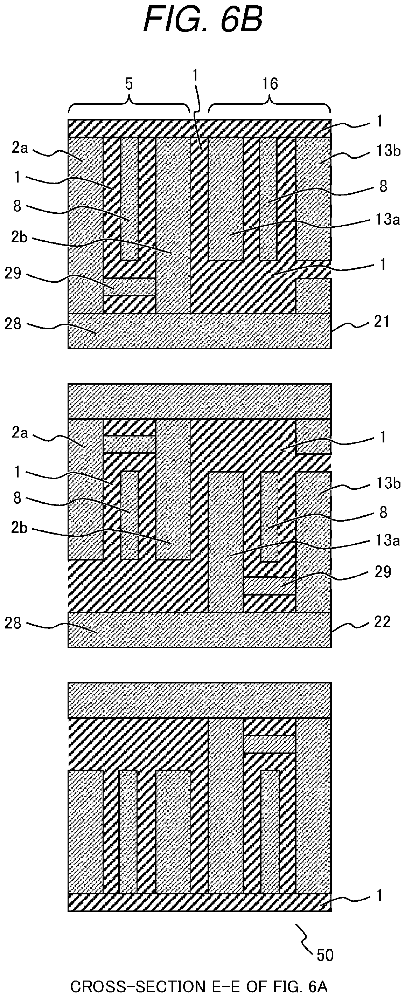

FIG. 6A and FIG. 6B are drawings illustrating an example of a multilayer printed circuit board as the wiring member 50 according to the present embodiment. FIG. 6A is a front view of the multilayer printed circuit board and FIG. 6B is a cross-sectional view taken along line E-E of FIG. 6A.

The multilayer printed circuit board shown in FIG. 6A and FIG. 6B includes a positive electrode wiring member 5, a negative electrode wiring member 16, and an insulating material 1 provided between the positive electrode wiring member 5 and the negative electrode wiring member 16. The positive electrode wiring member 5 includes a positive electrode conductor 2 (2a, 2b), an electromagnetic shield 8, and an insulating material 1 located therebetween. The negative electrode wiring member 16 includes a negative electrode conductor 13 (13a, 13b), an electromagnetic shield 8, an insulating material 1 located therebetween. The positive electrode conductor 2, the negative electrode conductor 13, and the electromagnetic shield 8 can be formed of a conductor in each layer of the printed circuit board. The insulating material 1 is an insulating member between the layers of the printed circuit board and can be formed of a substrate of the printed circuit board.

In the multilayer printed circuit board as the wiring member 50 according to the present embodiment, it is preferable that a conductor pattern in each layer is laid out so that the insulating material 1 is present at an end portion and the positive electrode conductor 2, the negative electrode conductor 13, and the electromagnetic shield 8 are positioned slightly inside the end portion. Due to this layout, the electromagnetic shield 8 can be effectively insulated from the positive electrode conductor 2 and the negative electrode conductor 13 at an end portion of the multilayer printed circuit board.

A description will be given to a configuration of an electrode of the printed circuit board. The printed circuit board includes a positive electrode 21 and a negative electrode 22 as electrodes.

The positive electrode 21 is formed of a through hole 28 whose interior is metallic plated, and is positioned in a plane where the negative electrode conductor 13b of the printed circuit board is present. This through hole 28 is connected to the positive electrode conductor 2a and the positive electrode conductor 2b. When the printed circuit board has a via 29 connecting the positive electrode conductor 2a with the positive electrode conductor 2b, the via is effective at reducing a conduction loss between the positive electrode conductor 2a and the positive electrode conductor 2b. As shown in FIG. 6A, an insulating material 1 is disposed around the positive electrode 21 to insulate the positive electrode 21 and the negative electrode conductor 13b from each other since the negative electrode conductor 13b is present around the positive electrode 21.

The negative electrode 22 is formed of a through hole 28 connecting the negative electrode conductor 13a and the negative electrode conductor 13b with each other and is located in a plane of the printed circuit board where the negative electrode conductor 13b is present. The negative electrode conductor 13a and the negative electrode conductor 13b are connected with each other through a via 29.

By utilizing the through hole 28, external devices such as a capacitor and a switching element are connected to the positive electrode 21 and the negative electrode 22. For example, when the diameter of the through hole 28 is slightly larger than the lead diameter of a device connected to the positive electrode 21 and the negative electrode 22, the device can be fixed to the printed circuit board by soldering with a lead of the device passed through the through hole 28. For example, in case of a device whose electrode is fixed to the printed circuit board with a screw, when the diameter of the through hole 28 is slightly larger than the diameter of the screw, the device can be fixed to the printed circuit board with the screw passed through the through hole 28.

Positions of the positive electrode 21 and the negative electrode 22 are not limited to the example shown in FIG. 6A and FIG. 6B. For example, the positive electrode 21 and the negative electrode 22 may be located in a plane where the positive electrode conductor 2a of the printed circuit board is present. In this disposition, since the positive electrode conductor 2a is present around the negative electrode 22, an insulating material 1 is installed around the negative electrode 22 for insulating the negative electrode 22 and the positive electrode conductor 2a from each other.

The multilayer printed circuit board as the wiring member 50 according to the present embodiment, similar to the wiring member 50 according to the first embodiment, can reduce an inductance and a power loss in a high-frequency current. The wiring member 50 according to the present embodiment enables the electromagnetic shield 8 to be effectively insulated from the positive electrode conductor 2 and the negative electrode conductor 13 at an end portion of the multilayer printed circuit board.

### FOURTH EMBODIMENT

A description will be given to a wiring member 50 for an electrical instrument according to the fourth embodiment of the present invention. In the present embodiment, a busbar will be described as an example of the wiring member 50. In the second embodiment and the third embodiment, an example where the insulating material 1 is a solid is described. The insulating material 1 does not need to be a solid and may be a gas such as air or a liquid such as insulating oil. In the present embodiment, a description will be given to the wiring member 50 (busbar) in which the insulating material 1 is air.

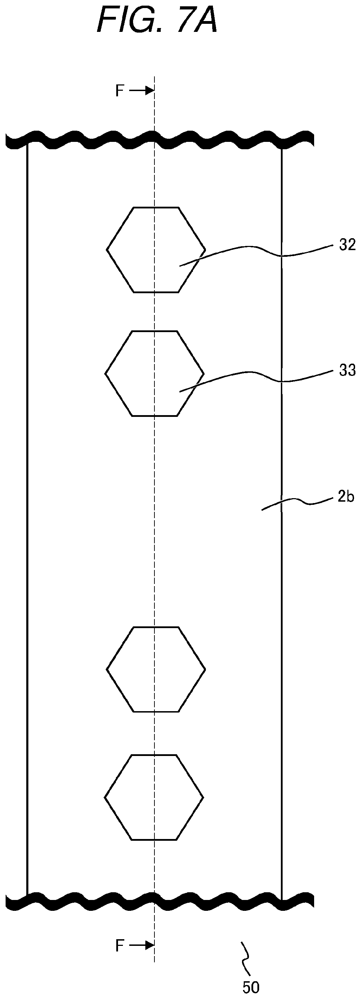

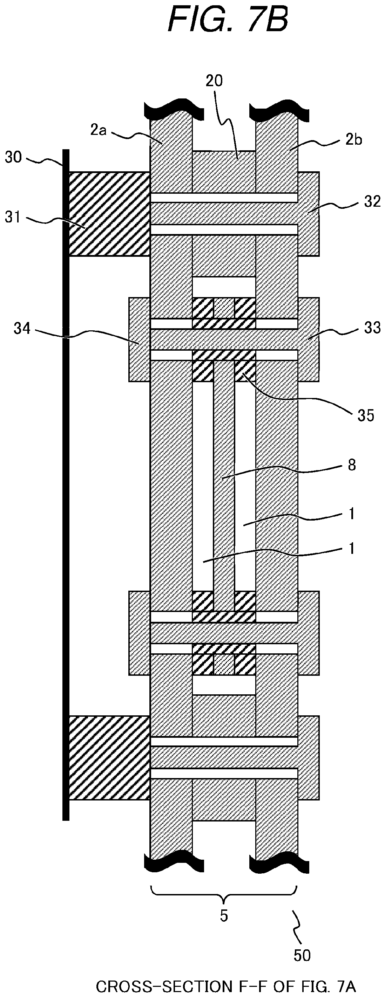

FIG. 7A and FIG. 7B are drawings illustrating an example of a busbar as the wiring member 50 according to the present embodiment. FIG. 7A is a front view of the busbar and FIG. 7B is a cross-sectional view taken along line F-F of FIG. 7A.

The busbar shown in FIG. 7A and FIG. 7B does not include a negative electrode wiring member 16 but includes a positive electrode wiring member 5 and also includes a positive electrode conductor 2 (2a, 2b), an electromagnetic shield 8 and an insulating material 1 located therebetween. The insulating material 1 is air.

The positive electrode conductor 2a and the positive electrode conductor 2b are electrically connected with each other through a spacer 20 as a conductor. The positive electrode conductor 2a and the positive electrode conductor 2b can be fixed to an insulator 31 with a bolt 32. The insulator 31 is fixed to an enclosure 30 to which the busbar is fixed.

The electromagnetic shield 8 is installed between the positive electrode conductor 2a and the positive electrode conductor 2b. The electromagnetic shield 8 can be installed, for example, by the following method. The electromagnetic shield 8 can be installed by installing insulating spacers 35 between the electromagnetic shield 8 and the positive electrode conductor 2a and between the electromagnetic shield 8 and the positive electrode conductor 2b, and fixing the positive electrode conductor 2a, the electromagnetic shield 8, the positive electrode conductor 2b, and the insulating spacers 35 with a bolt 33 and a nut 34.

The electromagnetic shield 8 has a hole which the bolt 33 penetrates. When the bolt 33 is formed of a conductor such as metal, the insulating spacer 35 is configurated to cover a side face of a hole in the electromagnetic shield 8. This configuration insulates the electromagnetic shield 8 from the bolt 33.

The busbar as the wiring member 50 according to the present embodiment, similar to the wiring member 50 according to the first embodiment, can reduce an inductance and a power loss in a high-frequency current. In addition, the wiring member 50 according to the present embodiment can insulate the electromagnetic shield 8 from conductors such as the positive electrode conductor 2.

### FIFTH EMBODIMENT

In the fifth embodiment, a description will be given to a power conversion device according to an embodiment of the present invention. The power conversion device according to the present embodiment may be any power conversion device including a wiring member 50 according to one of the embodiments of the present invention. In the present embodiment, a power conversion device that converts a DC current into a three-phase AC current will be described as an example of the power conversion device.

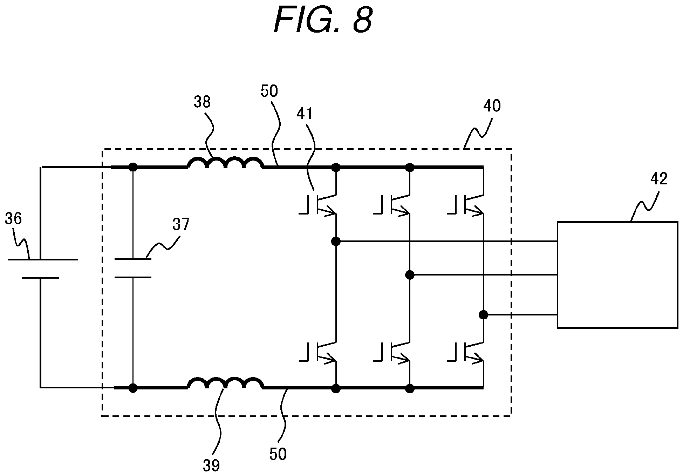

FIG. 8 is a drawing illustrating a circuit configuration of a power conversion device 40 according to the present embodiment. The power conversion device 40 is a device (for example, an inverter) that converts a DC current into a three-phase AC current, and is connectable to a DC power supply 36 and a three-phase AC load 42.

The power conversion device 40 includes a capacitor 37 and a switching element 41 as main components. The switching element 41 switches a DC current on and off. The power conversion device 40 further includes a wiring member 50 according to an embodiment of the present invention (for example, the wiring member 50 according to the second embodiment) as a wire (a conduction path of the DC power supply 36) connecting the capacitor 37 and the switching element 41. In FIG. 8, the wiring member 50 is indicated by bold line.

In general, in a wire that connects the capacitor 37 and the switching element 41, a positive-electrode-side parasitic inductance 38 and a negative-electrode-side parasitic inductance 39 are present as inductance. At a turn-off time when the switching element 41 changes from on state to off state, a current flowing through this wire drastically varies and high frequency components get contained in the current. For this reason, when the positive-electrode-side parasitic inductance 38 and the negative-electrode-side parasitic inductance 39 are large, an excessive surge voltage is applied to the switching element 41 and the switching element 41 can be broken.

The power conversion device 40 according to the present embodiment, including the wiring member 50 according to one of the embodiments of the present invention as a wire that connects the capacitor 37 and the switching element 41, can reduce an inductance and a power loss in a high-frequency current (DC current containing high frequency components). That is, the power conversion device 40 according to the present embodiment can lower a surge voltage and prevent breakage of the switching element 41 since an inductance of a wire connecting the capacitor 37 and the switching element 41 is small.

The present invention is not limited to the above-mentioned embodiments and can be variously modified. For example, the above-mentioned embodiments are described in detail for making the present invention understandable and the present invention need not be provided with all the configurations described above. A part of a configuration of some embodiment may be replaced with a configuration of any other embodiment. A configuration of some embodiment may be added to a configuration of any other embodiment. A part of a configuration of each embodiment may be deleted and any other configuration may be added thereto or substituted therefor.

### LIST OF REFERENCE CHARACTERS

1: insulating material, 2, 2a, 2b: positive electrode conductor, 3: current, 4: magnetic flux, 5: positive electrode wiring member, 6: current, 7: magnetic flux, 8: electromagnetic shield, 9: eddy current, 10: magnetic flux, 11: eddy current, 12: eddy current, 13, 3a, 13b: negative electrode conductor, 14: current, 15: magnetic flux, 16: negative electrode wiring member, 17: current, 18: magnetic flux, 19: eddy current, 20: spacer, 21: positive electrode, 22: negative electrode, 23: a step-bent portion, 24: between-positive-negative-electrodes insulating plate, 25: electromagnetic shield insulating plate, 26: electromagnetic shield insulating sheet, 27: side face insulating sheet, 28: through hole, 29: via, 30: enclosure, 31: insulator, 32: bolt, 33: bolt, 34: nut, 35: insulating spacer, 36: DC power supply, 37: capacitor, 38: positive-electrode-side parasitic inductance, 39: negative-electrode-side parasitic inductance, 40: power conversion device, 41: switching element, 42: three-phase AC load, 50: wiring member.

## Claims

1. A wiring member for an electrical instrument, comprising:
a plurality of first conductors electrically connected and laminated with each other;
a second conductor provided between the first conductors and not electrically connected with any other conductors; and
insulating materials provided between each of the first conductors and the second conductor.

2. The wiring member for an electrical instrument according to Claim 1, comprising:
two members each including the first conductors, the second conductor, and the insulating materials,
wherein the two members are opposed to each other in a laminating direction of the first conductors, and include an insulating material between the members.

3. The wiring member for an electrical instrument according to Claim 2,
wherein the first conductors of one of the members are connected with a positive electrode of a DC power supply, and
wherein the first conductors of the other of the members are connected with a negative electrode of a DC power supply.

4. A power conversion device comprising:
a capacitor;
a switching element that switches a DC current on and off; and
a wire connecting the capacitor and the switching element,
wherein the wire is the wiring member according to Claim 3.
